# FASCICULE DE BREVET EUROPEEN

(11) **EP 4 438 876 B1**
(45) Date de publication et mention de la délivrance du brevet: **28.05.2025**
(21) Numéro de dépôt: 24165084.5
(22) Date de dépôt: 21.03.2024
(51) Int. Cl.: F02C 7/18, F02K 3/06, F02K 3/115

(54) **ENSEMBLE DE PROPULSION COMPRENANT AU MOINS UN DISPOSITIF DE VENTILATION RÉGULÉ, AÉRONEF COMPRENANT AU MOINS UN TEL ENSEMBLE DE PROPULSION**
ANTRIEBSANORDNUNG MIT MINDESTENS EINER GEREGELTEN BELÜFTUNGSVORRICHTUNG, LUFTFAHRZEUG MIT MINDESTENS EINER SOLCHEN ANTRIEBSANORDNUNG
PROPULSION ASSEMBLY COMPRISING AT LEAST ONE REGULATED VENTILATION DEVICE, AIRCRAFT COMPRISING AT LEAST ONE SUCH PROPULSION ASSEMBLY

(30) Priorité: 31.03.2023 FR 2303137
(43) Date de publication de la demande: 02.10.2024
(73) Titulaire: AIRBUS OPERATIONS (S.A.S.), 31060 Toulouse (FR)
(72) Inventeur: FLEMIN, Christian, 31060 TOULOUSE (FR); PONS, François, 31060 TOULOUSE (FR)
(74) Mandataire: Airbus-OPS SAS

(56) Documents cités:
- US-A1- 2013 186 102
- US-A1- 2016 123 185
- US-A1- 2018 016 933

## Description

La présente demande se rapporte à un ensemble de propulsion comprenant au moins un dispositif de ventilation configuré pour refroidir au moins une zone de l'ensemble de propulsion ainsi qu'à un aéronef comprenant au moins un tel ensemble de propulsion.

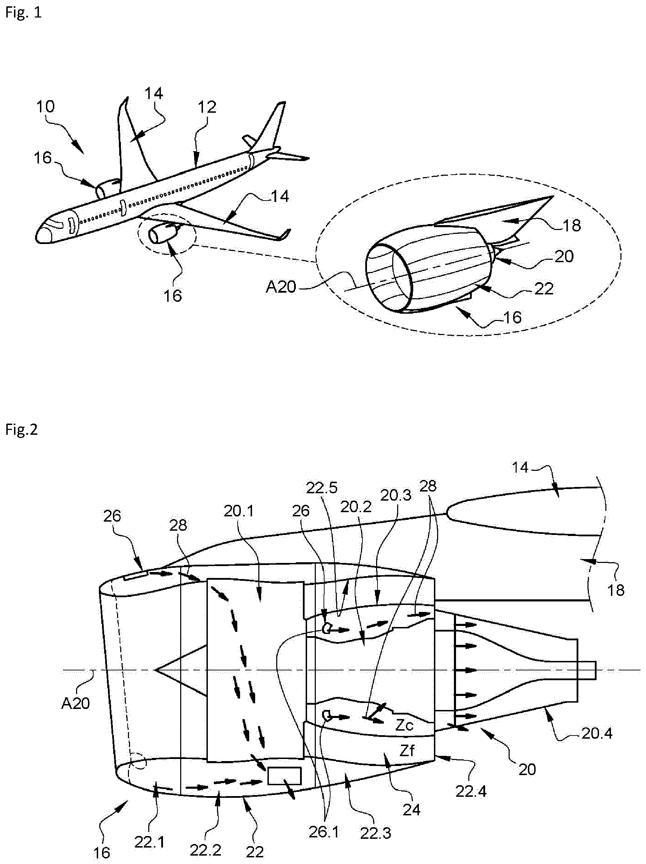

Selon un mode de réalisation visible sur la figure 1, un aéronef 10 comprend un fuselage 12, des ailes 14 positionnées de part et d'autre du fuselage ainsi que des ensembles de propulsion 16 positionnés sous les ailes et reliés à ces dernières par des mâts 18. Chaque ensemble de propulsion 16 comprend une motorisation 20 ainsi qu'une nacelle 22 entourant la motorisation 20 et permettant notamment de canaliser un flux d'air en direction de la motorisation 20.

La motorisation 20 présente un axe de rotation A20. Pour la suite de la description, une direction longitudinale est une direction parallèle à l'axe de rotation A20. Un plan longitudinal est un plan contenant l'axe de rotation A20. Un plan transversal est un plan perpendiculaire à l'axe de rotation A20. Les notions avant/amont et arrière/aval font référence au sens d'écoulement du flux d'air dans la motorisation 20 en fonctionnement, qui s'écoule de l'avant/amont vers l'arrière/aval.

Selon un mode de réalisation visible sur la figure 2, l'ensemble de propulsion est un turboréacteur à double flux. La motorisation 20 comprend, de l'avant vers l'arrière, une soufflante 20.1, un cœur de moteur 20.2, une paroi externe 20.3 entourant le cœur de moteur 20.2 ainsi qu'une première tuyère 20.4 dans le prolongement du cœur de moteur 20.2. La paroi externe 20.3 est également appelée structure interne fixe ou IFS (pour Inner fixed structure en anglais).

La nacelle 22 présente généralement une structure tubulaire comprenant une entrée d'air 22.1 en amont de la motorisation 20, une partie intermédiaire 22.2 destinée à entourer la soufflante 20.1, une partie arrière 22.3 pouvant intégrer des moyens d'inversion de poussée, positionnée autour de la paroi externe 20.3 et généralement terminée par une deuxième tuyère 22.4. La nacelle 22 présente également une paroi interne 22.5 espacée de la motorisation 20, notamment de sa paroi externe 20.3.

En fonctionnement, un flux primaire circule dans le cœur de moteur 20.2 et sort via la première tuyère 20.4. Un flux secondaire sortant de la soufflante 20.1 circule dans un conduit annulaire 24 délimité par la paroi externe 20.3 de la motorisation 20 et la paroi interne 22.5 de la nacelle 22. Les flux primaire et secondaire sont éjectés via les première et deuxième tuyères 20.4, 22.4. Selon une configuration, la paroi externe 20.3 de la motorisation 20 comprend une barrière thermique et sépare une zone chaude Zc, à l'intérieur de la motorisation 20, et une zone froide Zf à l'extérieur de la motorisation 20, dans le conduit annulaire 24.

Comme illustré sur la figure 2, l'ensemble de propulsion 16 comprend au moins un dispositif de ventilation 26 configuré pour refroidir certaines zones de l'ensemble de propulsion 16, en particulier le cœur de moteur 20.2 ainsi que la zone comprise entre la paroi externe 20.3 et le cœur de moteur 20.2 (cette zone étant appelée Core zone en anglais) où sont installés des équipements et des systèmes de la motorisation 20. Ce dispositif de ventilation 26 génère des flux d'air 28 froid dans la motorisation 20 et la nacelle 22.

Ce dispositif de ventilation 26 comprend, entre autres, au moins un trou de ventilation 26.1, traversant la paroi externe 20.3 de la motorisation 20, qui présente une section de passage fixe. Le dispositif de ventilation 26 est conçu pour les besoins les plus importants, notamment lors de la phase de décollage de l'aéronef avec une température élevée au sol et une poussée de la motorisation 20 élevée entraînant un échauffement important de celle-ci.

Par conséquent, pour certaines phases de vol comme la phase de croisière par exemple, la section de passage du trou de passage 26.1 est surdimensionnée pour les besoins en refroidissement. Ce surdimensionnement conduit à capter trop d'air dans le flux secondaire et à réduire la poussée de l'ensemble de propulsion 16, ce qui se traduit par une augmentation de la consommation énergétique à poussée et conditions de vol identiques.

Le document US2018/016933 A1 divulgue un ensemble de propulsion d'aéronef selon l'art antérieur.

La présente invention vise à remédier à tout ou partie des inconvénients de l'art antérieur.

A cet effet, l'invention a pour objet un ensemble de propulsion d'aéronef comportant une motorisation, une nacelle positionnée autour de la motorisation, un conduit annulaire positionné entre la motorisation et la nacelle et configuré pour canaliser un flux d'air froid ainsi qu'au moins un dispositif de ventilation configuré pour refroidir au moins une zone à refroidir de l'ensemble de propulsion, le dispositif de ventilation comportant au moins un trou de ventilation qui débouche dans la zone à refroidir.

Selon l'invention, le dispositif de ventilation est régulé et comprend :
- au moins un clapet mobile entre une position fermée dans laquelle le clapet obture le trou de ventilation et une position ouverte dans laquelle le clapet dégage au moins partiellement le trou de ventilation,
- au moins un générateur thermoélectrique configuré pour générer un courant électrique en récupérant une partie de la chaleur produite par la motorisation,
- au moins une commande d'asservissement configurée pour contrôler la position du clapet en utilisant le courant électrique généré par le générateur thermoélectrique.

Cette solution permet d'obtenir un dispositif de ventilation régulé, la section de passage du trou de ventilation équipé du clapet ainsi que le débit d'air prélevé pouvant être ajustés en fonction des besoins en refroidissement. L'utilisation d'un générateur thermoélectrique permet d'utiliser une ressource disponible dans l'ensemble de propulsion pour déplacer le clapet et/ou réguler sa position.

Selon une autre caractéristique, le dispositif de ventilation comprend au moins un actionneur électrique configuré pour déplacer le clapet dans au moins un premier sens parmi un sens allant de la position ouverte vers la position fermée et un sens allant de la position fermée vers la position ouverte.

Selon une autre caractéristique, le dispositif de ventilation comprend au moins un ressort configuré pour pousser et maintenir le clapet en position ouverte, l'actionneur électrique étant configuré pour déplacer le clapet de la position ouverte vers la position fermée à l'encontre des efforts exercés par le ressort.

Selon un mode de réalisation, le dispositif de ventilation comprend au moins un câble électrique reliant le générateur thermoélectrique et l'actionneur électrique de sorte que le courant électrique généré par le générateur thermoélectrique alimente l'actionneur électrique.

Selon une autre caractéristique, le dispositif de ventilation comprend au moins un convertisseur comportant une fonction configurée pour transformer le courant électrique généré par le générateur thermoélectrique en un courant d'alimentation pour alimenter l'actionneur électrique, une valeur donnée du courant d'alimentation étant une fonction d'une valeur donnée du courant généré par le générateur thermoélectrique et correspondant à une position donnée du clapet.

Selon un autre mode de réalisation, le dispositif de ventilation comprend au moins un relais configuré pour recevoir un courant de puissance et le transmettre à l'actionneur électrique en tant que courant d'alimentation en fonction d'un courant de commande généré par le générateur thermoélectrique.

Selon une autre caractéristique, le relais est configuré pour occuper un état activé, lorsque le courant de commande présente une valeur inférieure à une valeur seuil, dans lequel le relais autorise le passage du courant de puissance, le courant d'alimentation présentant une valeur égale à celle du courant de puissance, ainsi qu'un état désactivé, lorsque le courant de commande présente une valeur supérieure ou égale à la valeur seuil, dans lequel le relais bloque le courant de puissance, le courant d'alimentation présentant une valeur nulle.

Selon une autre caractéristique, le dispositif de ventilation comprend au moins un interrupteur, positionné entre une alimentation de puissance et le relais, configuré pour occuper un état passant dans lequel l'interrupteur transmet le courant de puissance au relais et un état bloqué dans lequel l'interrupteur bloque le courant de puissance.

Selon une autre caractéristique, le générateur thermoélectrique est positionné en aval du trou de ventilation de sorte qu'un flux d'air passant à travers le trou de ventilation impacte le générateur thermoélectrique.

Selon une autre caractéristique, le générateur thermoélectrique comprend une première face en contact avec une source froide ou avec une ambiance froide refroidie par une source froide ainsi qu'une deuxième face en contact avec une source chaude ou une ambiance chaude chauffée par une source chaude qui présente un gradient de température avec la source froide ou l'ambiance froide, le générateur thermoélectrique étant positionné de manière à ce que sa deuxième face soit en contact avec une source chaude à refroidir ou avec une ambiance chaude à refroidir.

Selon une configuration, la motorisation comprend un cœur de moteur délimité par une enveloppe, une paroi externe entourant le cœur de moteur, distante de l'enveloppe et délimitant le conduit annulaire, ainsi qu'une zone intermédiaire positionnée entre l'enveloppe du cœur de moteur et la paroi externe, la paroi externe présentant une face intérieure orientée vers le cœur de moteur et une face extérieure opposée à la face intérieure, la zone à refroidir correspondant à la zone intermédiaire et le trou de ventilation traversant la paroi externe.

Selon un agencement, le générateur thermoélectrique est positionné au niveau de la paroi externe et présente une première face située au niveau de la face extérieure de la paroi externe et en contact avec le flux d'air froid ainsi qu'une deuxième face en contact avec un air chaud présent dans la zone intermédiaire.

Selon un autre agencement, le générateur thermoélectrique est positionné au niveau de l'enveloppe du cœur de moteur et présente une première face en contact avec un air présent dans la zone intermédiaire ainsi qu'une deuxième face plaquée contre l'enveloppe du cœur de moteur.

L'invention a également pour objet un aéronef comprenant au moins un ensemble de propulsion selon l'une des caractéristiques précédentes.

D'autres caractéristiques et avantages ressortiront de la description de l'invention qui va suivre, description donnée à titre d'exemple uniquement, en regard des dessins annexés parmi lesquels :
- La figure 1 est une vue en perspective d'un aéronef et en détail d'un ensemble de propulsion,
- La figure 2 est une coupe longitudinale d'un ensemble de propulsion illustrant un mode de réalisation de l'art antérieur,
- La figure 3 est une coupe longitudinale d'une partie d'un ensemble de propulsion comportant un dispositif de ventilation illustrant un mode de réalisation de l'invention,
- La figure 4 est une représentation schématique d'un dispositif de ventilation comportant un clapet en position ouverte illustrant un mode de réalisation de l'invention,
- La figure 5 est une représentation schématique du dispositif de ventilation visible sur la figure 4, le clapet étant en position fermée,
- La figure 6 est une coupe longitudinale d'une partie d'un ensemble de propulsion comportant un dispositif de ventilation illustrant un autre mode de réalisation de l'invention,
- La figure 7 est une représentation schématique d'un dispositif de ventilation comportant un clapet en position ouverte illustrant un autre mode de réalisation de l'invention,
- La figure 8 est une représentation schématique du dispositif de ventilation visible sur la figure 7, le clapet étant en position fermée.

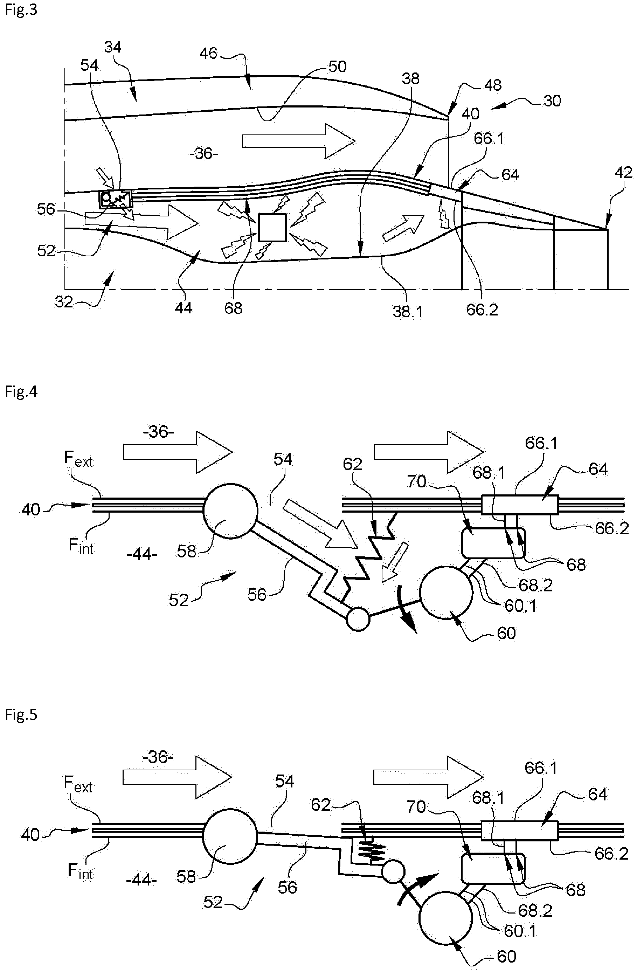

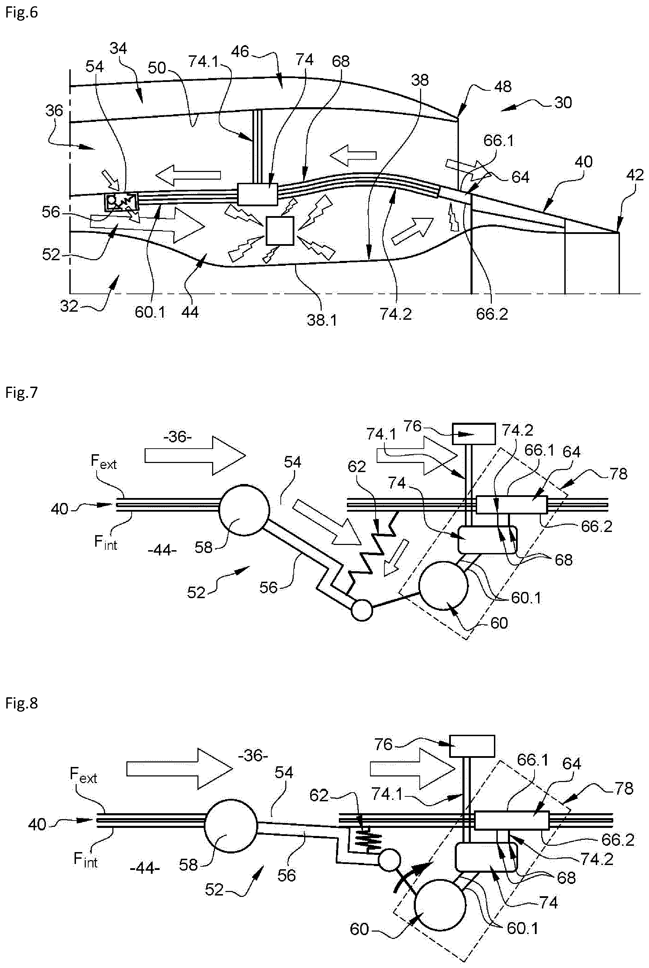

Selon un mode de réalisation visible sur les figures 3 et 6, un ensemble de propulsion 30 d'un aéronef comprend une motorisation 32, une nacelle 34 positionnée autour de la motorisation 32 ainsi qu'un conduit annulaire 36 configuré pour canaliser un flux d'air froid, appelé flux secondaire, entre la motorisation 32 et la nacelle 34.

La motorisation 32 comprend, de l'avant vers l'arrière, une soufflante (non représentée), un cœur de moteur 38 (cette zone étant appelée Core zone en anglais) délimité par une enveloppe 38.1, une paroi externe 40 entourant le cœur de moteur 38, distante de son enveloppe 38.1, ainsi qu'une première tuyère 42 prolongeant le cœur de moteur 38. La paroi externe 40 est également appelée structure interne fixe ou IFS (pour Inner fixed structure en anglais). Selon une configuration, la paroi externe 40 comprend au moins une partie espacée du cœur de moteur 38 qui présente une face intérieure Fint orientée vers le cœur de moteur 38 et une face extérieure Fext opposée à la face intérieure Fint. Selon un mode de réalisation, la paroi externe 40 comprend un panneau sandwich qui présente au moins une structure alvéolaire intercalée entre une peau extérieure formant la face extérieure Fext et une peau intérieure formant la face intérieure Fint. Selon une conception, la paroi externe 40 comprend une isolation thermique au niveau de la face intérieure Fint.

La motorisation 32 comprend une zone intermédiaire 44 positionnée entre l'enveloppe 38.1 du cœur de moteur 38 et la paroi externe 40.

La nacelle 34 présente généralement une structure tubulaire comprenant une entrée d'air en amont de la motorisation 32, une partie intermédiaire destinée à entourer la soufflante, une partie arrière 46 pouvant intégrer des moyens d'inversion de poussée, positionnée autour de la paroi externe 40 et généralement terminée par une deuxième tuyère 48. La nacelle 34 présente également une paroi interne 50 espacée de la motorisation 32, notamment de sa paroi externe 40.

En fonctionnement, un flux primaire circule dans le cœur de moteur 38 et sort via la première tuyère 42. Un flux secondaire sortant de la soufflante circule dans le conduit annulaire 36 délimité par la paroi externe 40 de la motorisation 32 et la paroi interne 50 de la nacelle 34. Les flux primaire et secondaire sont éjectés via les première et deuxième tuyères 42, 48. La paroi externe 40 de la motorisation 32 sépare une zone chaude Zc à l'intérieur de la motorisation 32, dans la zone intermédiaire 44, et une zone froide Zf à l'extérieur de la motorisation 32, dans le conduit annulaire 36.

L'ensemble de propulsion 30, la motorisation 32 et la nacelle 34 ne sont pas plus décrits car ils peuvent être identiques à ceux de l'art antérieur.

L'ensemble de propulsion 30 comprend au moins un dispositif de ventilation 52, configuré pour refroidir au moins une zone à refroidir de l'ensemble de propulsion 30 et comprenant au moins un trou de ventilation 54 qui présente une section de passage, traversant une première paroi en contact avec le flux d'air froid et débouchant dans la zone à refroidir, la première paroi séparant des zones chaude et froide Zc, Zf. Selon une configuration, la zone à refroidir correspondant à la zone intermédiaire 44 et la première paroi correspondant à la paroi externe 40.

Selon des modes de réalisation visibles sur les figures 4, 5, 7 et 8, le dispositif de ventilation 52 est dit régulé car il permet la régulation de la ventilation. A cet effet, il comprend un clapet 56 ainsi qu'une articulation 58, reliant le clapet 56 et la première paroi, configurée pour permettre au clapet 56 d'occuper une position fermée dans laquelle le clapet 56 obture le trou de ventilation 54 et une position ouverte dans laquelle le clapet 56 dégage au moins partiellement le trou de ventilation 54. Selon une configuration, le clapet 56 est configuré pour occuper une première position extrême correspondant à la position fermée dans laquelle la section de passage du trou de ventilation 54 présente une valeur nulle ainsi qu'une deuxième position extrême correspondant à une position totalement ouverte dans laquelle la section de passage du trou de ventilation 54 présente une valeur maximale et des positions intermédiaires pour chacune desquelles la section de passage du trou de ventilation 54 présente une valeur comprise entre la valeur nulle et la valeur maximale. Selon un mode de réalisation, l'articulation 58 comprend une liaison pivotante. En position ouverte, le clapet 56 est situé dans la zone chaude Zc.

Le dispositif de ventilation 52 comprend au moins un actionneur électrique 60 configuré pour déplacer le clapet 56. L'actionneur électrique 60 est alimenté par un courant d'alimentation 60.1 présentant une valeur donnée. Selon un agencement, l'actionneur électrique 60 comprend une première extrémité reliée à la première paroi ainsi qu'une deuxième extrémité reliée au clapet 56.

Selon une configuration, l'actionneur électrique 60 est configuré pour positionner le clapet 56 dans une position donnée entre la position fermée et la position totalement ouverte en fonction de la valeur du courant d'alimentation 60.1.

Selon un mode de réalisation, le dispositif de ventilation 52 comprend au moins un ressort 62 configuré pour déplacer le clapet 56 en position ouverte et le maintenir dans cette position. En complément, l'actionneur électrique 60 est configuré pour déplacer le clapet 56 de la position ouverte vers la position fermée à l'encontre des efforts exercés par le ressort 62. Pour la présente demande, le terme ressort 62 couvre tout moyen de rappel.

Plus généralement, l'actionneur électrique 60 est configuré pour déplacer le clapet 56 dans au moins un premier sens parmi un sens allant de la position ouverte vers la position fermée et un sens allant de la position fermée vers la position ouverte ainsi qu'au moins un ressort 62 configuré pour déplacer le clapet dans un deuxième sens opposé au premier sens. La solution dans laquelle le ressort 62 pousse le clapet 56 en position ouverte est privilégiée car le trou de ventilation 54 est automatiquement en position totalement ouverte en cas d'un dysfonctionnement notamment de l'actionneur électrique 60.

Selon les premier et deuxième modes de réalisation visibles sur les figures 3 à 8, le dispositif de ventilation 52 comprend au moins un générateur thermoélectrique 64 appelé TEG (pour Thermo Electrical Generator en anglais) comprenant une première face 66.1 en contact avec une source froide ou avec une ambiance froide refroidie par une source froide ainsi qu'une deuxième face 66.2 en contact avec une source chaude ou une ambiance chaude chauffée par une source chaude qui présente un gradient de température avec la source froide ou l'ambiance froide, le générateur thermoélectrique 64 produisant un courant électrique à une valeur donnée en fonction du gradient de température entre les sources froide et chaude. Le transfert de chaleur entre la source froide et la première face 66.1 peut être obtenu par conduction lorsque la source froide est en contact direct avec la première face 66.1 ou par convection lorsque la source froide est distante de la première face 66.1. Le transfert de chaleur entre la source chaude et la deuxième face 66.2 peut être obtenu par conduction lorsque la source chaude est en contact direct avec la deuxième face 66.2 ou par convection lorsque la source chaude est distante de la deuxième face 66.2.

Selon une configuration, le générateur thermoélectrique 64 comprend au moins une plaque comportant des semi-conducteurs et utilise l'effet Seebeck pour produire de l'électricité en fonction du gradient de température entre les première et deuxième faces 66.1, 66.2.

Selon le premier mode de réalisation visible sur les figures 3 à 5, le courant électrique généré par le générateur thermoélectrique 64 est utilisé pour alimenter l'actionneur électrique 60. A cet effet, le dispositif de ventilation 52 comprend au moins un câble électrique 68 reliant le générateur thermoélectrique 64 et l'actionneur électrique 60. Selon une configuration, le dispositif de ventilation 52 comprend au moins un convertisseur 70, le câble électrique 68 comportant un premier tronçon 68.1 reliant le générateur thermoélectrique 64 et le convertisseur 70 ainsi qu'un deuxième tronçon 68.2 reliant le convertisseur 70 et l'actionneur électrique 60. Pour la présente demande, on entend par un câble électrique un unique câble électrique ou plusieurs câbles électriques regroupés en un faisceau de câbles.

Le convertisseur 70 comprend une fonction configurée pour transformer le courant électrique, à faible valeur, généré par le générateur thermoélectrique 64 en un courant d'alimentation 60.1 pour l'actionneur électrique, une valeur donnée du courant d'alimentation 60.1 étant une fonction d'une valeur donnée du courant électrique généré par le générateur thermoélectrique 64 et correspondant à une position donnée du clapet 56. Cette fonction permet de faire correspondre une position fixe de l'actionneur électrique 60 (donc un angle d'ouverture du clapet 56) avec une valeur du courant produit par le générateur thermoélectrique 64. Cette solution permet d'obtenir une régulation fine de la ventilation.

Selon ce premier mode de réalisation, le dispositif de ventilation 52 est autonome, la position du clapet 56 étant ajustée en fonction du gradient de température entre les sources froide et chaude Zf, Zc. Plus le gradient de température est important, ce qui correspond à un besoin de refroidissement important, plus le clapet 56 occupe une position proche de la position totalement ouverte. A contrario, moins le gradient de température est important, ce qui correspond à un faible besoin de refroidissement, plus le clapet 56 occupe une position proche de la position fermée.

Selon une configuration, la fonction du convertisseur 70 est configurée de manière à limiter les positions fixes occupées par l'actionneur électrique 60. Ainsi, une position fixe donnée de l'actionneur électrique 60 correspond à au moins une plage de gradients de température et non à un gradient de température.

Selon un deuxième mode de réalisation visible sur les figures 6 à 8, le dispositif de ventilation 52 comprend au moins un relais 74 configuré pour recevoir un courant de puissance 74.1 à forte valeur, provenant d'une alimentation électrique de l'aéronef, et le transmettre à l'actionneur électrique 60 en tant que courant d'alimentation 60.1 en fonction d'un courant de commande 74.2.

Le courant de commande 74.2 est généré par le générateur thermoélectrique 64.

Selon ce deuxième mode de réalisation, l'aéronef comprend une alimentation de puissance 76 générant le courant de puissance 74.1 destiné au dispositif de ventilation 52, plus particulièrement au relais 74. Selon un agencement, le dispositif de ventilation 52 comprend au moins un interrupteur, positionné entre l'alimentation de puissance 76 et le relais 74, configuré pour occuper un état passant dans lequel l'interrupteur transmet le courant de puissance 74.1 au relais 74 et un état bloqué dans lequel l'interrupteur bloque le courant de puissance 74.1. Ainsi, le dispositif de ventilation 52 peut être désactivé simplement. Cet interrupteur est positionné dans l'aéronef de manière à être actionnable par opérateur. Cette solution est plus particulièrement adaptée pour les opérations manuelles au sol. Ainsi, la fonctionnalité du dispositif de ventilation 52 peut être inhibée ou testée au sol.

Selon une configuration, le relais 74 est configuré pour occuper un état activé, lorsque le courant de commande 74.2 présente une valeur inférieure à une valeur seuil, dans lequel le relais 74 autorise le passage du courant de puissance 74.1, le courant d'alimentation 60.1 de l'actionneur électrique 60 présentant une valeur égale à celle du courant de puissance 74.1 (pour placer le clapet 56 en position fermée en cas de conditions froides), ainsi qu'un état désactivé, lorsque le courant de commande 74.2 présente une valeur supérieure ou égale à la valeur seuil, dans lequel le relais 74 bloque le courant de puissance 74.1, le courant d'alimentation 60.1 de l'actionneur électrique 60 présentant une valeur nulle (pour placer le clapet 56 en position totalement ouverte en cas de conditions chaudes ou d'un dysfonctionnement). La valeur du courant de commande 74.2 étant proportionnelle au gradient de température entre les sources chaude et froide Zc, Zf, la valeur seuil du courant de commande 74.2 correspond à une valeur déterminée du gradient de température entre les sources chaude et froide, Zc, Zf.

Selon cette configuration, tant que le gradient de température est supérieur ou égal à la valeur déterminée (c'est-à-dire en conditions chaudes), ce qui correspond à une situation pour laquelle un refroidissement est nécessaire, le courant de commande 74.2 a une valeur inférieure ou égale à la valeur seuil. Par conséquent, le relais 74 est à l'état désactivé, le courant d'alimentation 60.1 a une valeur nulle et le ressort 62 maintient le clapet 56 dans la position totalement ouverte.

Dès que le gradient de température est inférieur ou égal à la valeur déterminée (c'est-à-dire en conditions froides), ce qui correspond à une situation pour laquelle un refroidissement n'est pas nécessaire, le courant de commande 74.2 a une valeur supérieure à la valeur seuil. Par conséquent, le relais est à l'état activé, le courant d'alimentation 60.1 présente une valeur égale à celle du courant de puissance et le clapet 56 occupe une position donnée en fonction de la valeur du courant de puissance.

Cette configuration simplifie l'asservissement de la position du clapet 56.

Selon un mode de fonctionnement, le courant de puissance 74.1 est modulé en amont du relais en fonction de la position souhaitée pour le clapet 56.

Selon un autre mode de fonctionnement, le courant de puissance 74.1 a une valeur fixe et le relais 74 comprend une fonction configurée pour modifier la valeur du courant de puissance 74.1 en une valeur pour le courant d'alimentation 60.1 qui est une fonction de la valeur du courant de commande 74.2 généré par le générateur thermoélectrique 64. En variante, le courant électrique produit par le générateur thermoélectrique 64 est converti par un convertisseur qui comprend une fonction de conversion (comme pour le premier mode de réalisation) en un courant de commande 74.2 pilotant le relais 74.

Bien entendu, l'invention n'est pas limitée à ces modes de réalisation pour l'asservissement du clapet 56.

Quel que soit le mode de réalisation, le dispositif de ventilation 52 est régulé. A cet effet, il comprend au moins un générateur thermoélectrique 64 ainsi qu'au moins une commande d'asservissement 78 configurée pour contrôler la position du clapet 56 en utilisant le courant électrique généré par le générateur thermoélectrique 64.

En présence d'un actionneur électrique 60, la commande d'asservissement 78 contrôle le courant d'alimentation 60.1 fourni à l'actionneur électrique 60 et donc la position du clapet 56 à partir d'un courant de puissance provenant d'au moins un générateur thermoélectrique 64 du dispositif de ventilation 52 et/ou d'une source de l'aéronef indépendante du dispositif de ventilation 52. Cette commande d'asservissement 78 est configurée pour moduler la valeur du courant d'alimentation 60.1 à partir d'au moins une caractéristique d'un courant de commande, qui peut être la valeur du courant fourni par au moins un générateur thermoélectrique 64 du dispositif de ventilation 52.

Selon une première configuration visible sur les figures 3 et 6, le générateur thermoélectrique 64 est positionné au niveau de la paroi externe 40, sa première face 66.1 étant située au niveau de la face extérieure Fext de la paroi externe 40 et en contact avec le flux secondaire froid, sa deuxième face 66.2 étant en contact avec l'air chaud présent dans la zone intermédiaire 44. Selon ce positionnement, le gradient de température maximal est de l'ordre d'une centaine de degrés en fonctionnement. Selon cette configuration, le câble électrique 68 est intégré dans la paroi externe 40. Selon cette première configuration, le générateur thermoélectrique 64 est positionné proche d'un plan transversal passant par le bord de fuite de la deuxième tuyère 48.

Selon une autre configuration, le générateur thermoélectrique 64 est positionné au niveau de l'enveloppe 38.1 du cœur de moteur 38 qui est très chaude, sa deuxième face 66.2 étant plaquée contre l'enveloppe 38.1, la première face 66.1 étant en contact avec l'air moins chaud présent dans la zone intermédiaire 44. Selon ce positionnement, le gradient de température maximal peut dépasser les 300°C. Ainsi, dans cette deuxième configuration, le courant fourni par le générateur thermoélectrique 64 peut présenter une valeur nettement supérieure à celle du courant fourni par un générateur thermoélectrique 64 positionné selon la première configuration. Toutefois, l'intégration du câble électrique 68 dans la zone intermédiaire 44 s'avère plus complexe.

Selon un agencement visible sur les figures 3 et 6, le générateur thermoélectrique 64 est positionné en aval du trou de ventilation 54 dans une zone chaude de sorte qu'un flux d'air passant à travers le trou de ventilation 54 et se réchauffant en circulant dans la zone chaude vers l'arrière de la motorisation 32 impacte le générateur thermoélectrique 64, plus particulièrement sa deuxième face 66.2.

Selon une configuration, le générateur thermoélectrique 64 est positionné de manière à ce que sa deuxième face 66.2 soit en contact direct avec une source chaude à refroidir ou avec une ambiance chaude à refroidir. Cette configuration permet d'obtenir un dispositif de ventilation qui s'auto-régule en fonction des besoins en refroidissement.

Bien entendu, l'invention n'est pas limitée aux modes de réalisation visibles sur les figures 3 à 8. Ainsi, le dispositif de ventilation 52 peut comprendre un ou plusieurs trou(s) de ventilation 54 et un ou plusieurs générateur(s) thermoélectrique(s) 64. En présence de plusieurs trous de ventilation 54, les clapets 56 de ces différents trous de ventilation 54 peuvent tous occuper la même position ou des positions différentes d'un trou de ventilation 54 à l'autre. Ainsi, pour au moins un trou de ventilation 54, le clapet 56 peut être en position fermée alors que les clapets 56 des autres trous de ventilation 54 occupent des positions plus ou moins ouvertes.

De plus, un même générateur thermoélectrique 64 peut être utilisé pour réguler la section de passage de plusieurs trous de ventilation 54.

Quel que soit le mode de réalisation, le dispositif de ventilation est régulé, la section de passage du trou de ventilation 54 équipé du clapet 56 n'étant pas constante mais pouvant varier en fonction des besoins en refroidissement. Ainsi, le flux d'air prélevé dans le flux secondaire est ajusté en fonction des besoins en refroidissement réels ou estimés et peut être automatiquement réduit durant certaines phases de vol, comme la phase de croisière pour laquelle les besoins en refroidissement sont inférieurs au besoin maximal de refroidissement. Même si cette solution conduit à augmenter la masse embarquée de l'aéronef, le gain de poussée est nettement supérieur, ce qui permet d'obtenir globalement une réduction de la consommation énergétique de l'aéronef.

De préférence, le dispositif de ventilation 52 comprend au moins un ressort 62 qui pousse le clapet 56. Cette solution est privilégiée car le trou de ventilation 54 est automatiquement en position totalement ouverte en cas de dysfonctionnement de l'actionneur électrique 60 ou de l'alimentation de puissance 76 provenant de l'aéronef ou du générateur thermoélectrique 64.

## Revendications

1. Ensemble de propulsion d'aéronef comportant une motorisation (32), une nacelle (34) positionnée autour de la motorisation (32), un conduit annulaire (36) positionné entre la motorisation (32) et la nacelle (34) et configuré pour canaliser un flux d'air froid ainsi qu'au moins un dispositif de ventilation (52) configuré pour refroidir au moins une zone à refroidir de l'ensemble de propulsion, le dispositif de ventilation comportant au moins un trou de ventilation (54) qui débouche dans la zone à refroidir, le dispositif de ventilation étant régulé et comprenant au moins un clapet (56) mobile entre une position fermée dans laquelle le clapet (56) obture le trou de ventilation (54) et une position ouverte dans laquelle le clapet (56) dégage au moins partiellement le trou de ventilation (54), ainsi qu'au moins un générateur thermoélectrique (64) configuré pour générer un courant électrique ; **caractérisé en ce que** le dispositif de ventilation comprend également au moins une commande d'asservissement (78) configurée pour contrôler la position du clapet (56) en utilisant le courant électrique généré par le générateur thermoélectrique (64).

2. Ensemble de propulsion selon la revendication précédente, **caractérisé en ce que** le dispositif de ventilation (52) comprend au moins un actionneur électrique (60) configuré pour déplacer le clapet (56) dans au moins un premier sens parmi un sens allant de la position ouverte vers la position fermée et un sens allant de la position fermée vers la position ouverte.

3. Ensemble de propulsion selon la revendication précédente, **caractérisé en ce que** le dispositif de ventilation (52) comprend au moins un ressort (62) configuré pour pousser et maintenir le clapet (56) en position ouverte, l'actionneur électrique (60) étant configuré pour déplacer le clapet (56) de la position ouverte vers la position fermée à l'encontre des efforts exercés par le ressort (62).

4. Ensemble de propulsion selon l'une des revendications 2 à 3, **caractérisé en ce que** le dispositif de ventilation (52) comprend au moins un câble électrique (68) reliant le générateur thermoélectrique (64) et l'actionneur électrique (60) de sorte que le courant électrique généré par le générateur thermoélectrique (64) alimente l'actionneur électrique (60).

5. Ensemble de propulsion selon la revendication précédente, **caractérisé en ce que** le dispositif de ventilation (52) comprend au moins un convertisseur (70) comportant une fonction configurée pour transformer le courant électrique généré par le générateur thermoélectrique (64) en un courant d'alimentation (60.1) pour alimenter l'actionneur électrique (60), une valeur donnée du courant d'alimentation (60.1) étant une fonction d'une valeur donnée du courant généré par le générateur thermoélectrique (64) et correspondant à une position donnée du clapet (56).

6. Ensemble de propulsion selon l'une des revendications 2 à 3, **caractérisé en ce que** le dispositif de ventilation (52) comprend au moins un relais (74) configuré pour recevoir un courant de puissance (74.1) et le transmettre à l'actionneur électrique (60) en tant que courant d'alimentation (60.1) en fonction d'un courant de commande (74.2) généré par le générateur thermoélectrique (64).

7. Ensemble de propulsion selon la revendication précédente, **caractérisé en ce que** le relais (74) est configuré pour occuper un état activé, lorsque le courant de commande (74.2) présente une valeur inférieure à une valeur seuil, dans lequel le relais (74) autorise le passage du courant de puissance (74.1), le courant d'alimentation (60.1) présentant une valeur égale à celle du courant de puissance (74.1), ainsi qu'un état désactivé, lorsque le courant de commande (74.2) présente une valeur supérieure ou égale à la valeur seuil, dans lequel le relais (74) bloque le courant de puissance (74.1), le courant d'alimentation (60.1) présentant une valeur nulle.

8. Ensemble de propulsion selon l'une des revendications 6 à 7, **caractérisé en ce que** le dispositif de ventilation (52) comprend au moins un interrupteur, positionné entre une alimentation de puissance (76) et le relais (74), configuré pour occuper un état passant dans lequel l'interrupteur transmet le courant de puissance (74.1) au relais (74) et un état bloqué dans lequel l'interrupteur bloque le courant de puissance (74.1).

9. Ensemble de propulsion selon l'une des revendications précédentes, **caractérisé en ce que** le générateur thermoélectrique (64) est positionné en aval du trou de ventilation (54) de sorte qu'un flux d'air passant à travers le trou de ventilation (54) impacte le générateur thermoélectrique (64).

10. Ensemble de propulsion selon l'une des revendications précédentes, **caractérisé en ce que** le générateur thermoélectrique (64) comprend une première face (66.1) en contact avec une source froide ou avec une ambiance froide refroidie par une source froide ainsi qu'une deuxième face (66.2) en contact avec une source chaude ou une ambiance chaude chauffée par une source chaude qui présente un gradient de température avec la source froide ou l'ambiance froide et **en ce que** le générateur thermoélectrique (64) est positionné de manière à ce que sa deuxième face (66.2) soit en contact avec une source chaude à refroidir ou avec une ambiance chaude à refroidir.

11. Ensemble de propulsion selon l'une des revendications précédentes, **caractérisé en ce que** la motorisation (32) comprend un cœur de moteur (38) délimité par une enveloppe (38.1), une paroi externe (40) entourant le cœur de moteur (38), distante de l'enveloppe (38.1) et délimitant le conduit annulaire (36), ainsi qu'une zone intermédiaire (44) positionnée entre l'enveloppe (38.1) du cœur de moteur (38) et la paroi externe (40), la paroi externe (40) présentant une face intérieure (Fint) orientée vers le cœur de moteur (38) et une face extérieure (Fext) opposée à la face intérieure (Fint), la zone à refroidir correspondant à la zone intermédiaire (44) et le trou de ventilation (54) traversant la paroi externe (40).

12. Ensemble de propulsion selon la revendication précédente, **caractérisé en ce que** le générateur thermoélectrique (64) est positionné au niveau de la paroi externe (40) et présente une première face (66.1) située au niveau de la face extérieure (Fext) de la paroi externe (40) et en contact avec le flux d'air froid ainsi qu'une deuxième face (66.2) en contact avec un air chaud présent dans la zone intermédiaire (44).

13. Ensemble de propulsion selon la revendication 11, **caractérisé en ce que** le générateur thermoélectrique (64) est positionné au niveau de l'enveloppe (38.1) du cœur de moteur (38) et présente une première face (66.1) en contact avec un air présent dans la zone intermédiaire (44) ainsi qu'une deuxième face (66.2) plaquée contre l'enveloppe (38.1).

14. Aéronef comprenant au moins un ensemble de propulsion selon l'une des revendications précédentes.

## Patentansprüche

1. Antriebsanordnung eines Flugzeugs, umfassend eine Motorisierung (32), eine Gondel (34), die um die Motorisierung (32) herum angeordnet ist, einen ringförmigen Kanal (36), der zwischen der Motorisierung (32) und der Gondel (34) angeordnet ist und dazu ausgestaltet ist, einen kalten Luftstrom zu kanalisieren, sowie mindestens eine Belüftungsvorrichtung (52), die dazu ausgestaltet ist, mindestens einen zu kühlenden Bereich der Antriebsanordnung zu kühlen, wobei die Belüftungsvorrichtung mindestens ein Belüftungsloch (54) umfasst, das in dem zu kühlenden Bereich mündet, wobei die Belüftungsvorrichtung geregelt ist und mindestens eine Klappe (56) aufweist, die zwischen einer geschlossenen Stellung, in der die Klappe (56) das Belüftungsloch (54) verschließt, und einer geöffneten Stellung, in der die Klappe (56) das Belüftungsloch (54) mindestens teilweise freigibt, beweglich ist, sowie mindestens einen thermoelektrischen Generator (64), der dazu ausgestaltet ist, einen elektrischen Strom zu erzeugen; **dadurch gekennzeichnet, dass** die Belüftungsvorrichtung auch mindestens eine Regelungssteuerung (78) aufweist, die dazu ausgestaltet ist, die Stellung der Klappe (56) unter Verwendung des von dem thermoelektrischen Generator (64) erzeugten Stroms zu steuern.

2. Antriebsanordnung nach dem vorhergehenden Anspruch, **dadurch gekennzeichnet, dass** die Belüftungsvorrichtung (52) mindestens einen elektrischen Aktor (60) aufweist, der dazu ausgestaltet ist, die Klappe (56) in mindestens eine erste Richtung unter einer von der geöffneten Stellung zur geschlossenen Stellung gehenden Richtung und einer von der geschlossenen Stellung zur geöffneten Stellung gehenden Richtung zu verlagern.

3. Antriebsanordnung nach dem vorhergehenden Anspruch, **dadurch gekennzeichnet, dass** die Belüftungsvorrichtung (52) mindestens eine Feder (62) aufweist, die dazu ausgestaltet ist, die Klappe (56) in die geöffnete Stellung zu drücken und dort zu halten, wobei der elektrische Aktor (60) dazu ausgestaltet ist, die Klappe (56) gegen die von der Feder (62) ausgeübten Kräfte aus der geöffneten Stellung in die geschlossene Stellung zu verlagern.

4. Antriebsanordnung nach einem der Ansprüche 2 bis 3, **dadurch gekennzeichnet, dass** die Belüftungsvorrichtung (52) mindestens ein Stromkabel (68) aufweist, das den thermoelektrischen Generator (64) und den elektrischen Aktor (60) verbindet, so dass der von dem thermoelektrischen Generator (64) erzeugte elektrische Strom den elektrischen Aktor (60) speist.

5. Antriebsanordnung nach dem vorhergehenden Anspruch, **dadurch gekennzeichnet, dass** die Belüftungsvorrichtung (52) mindestens einen Wandler (70) aufweist, der eine Funktion umfasst, die dazu ausgestaltet ist, den von dem thermoelektrischen Generator (64) erzeugten Strom in einen Speisestrom (60.1) zum Speisen des elektrischen Aktors (60) umzuwandeln, wobei ein bestimmter Wert des Speisestroms (60.1) eine Funktion eines bestimmten Werts des von dem thermoelektrischen Generator (64) erzeugten Stroms ist und einer bestimmten Stellung der Klappe (56) entspricht.

6. Antriebsanordnung nach einem der Ansprüche 2 bis 3, **dadurch gekennzeichnet, dass** die Belüftungsvorrichtung (52) mindestens ein Relais (74) aufweist, das dazu ausgestaltet ist, einen Leistungsstrom (74.1) zu empfangen und ihn an den elektrischen Aktor (60) als Speisestrom (60.1) weiterzuleiten in Abhängigkeit von einem Steuerstrom (74.2), der von dem thermoelektrischen Generator (64) erzeugt wird.

7. Antriebsanordnung nach dem vorhergehenden Anspruch, **dadurch gekennzeichnet, dass** das Relais (74) dazu ausgestaltet ist, einen aktivierten Zustand einzunehmen, wenn der Steuerstrom (74.2) einen Wert unter einem Schwellenwert aufweist, in dem das Relais (74) den Durchgang des Leistungsstroms (74.1) zulässt, wobei der Speisestrom (60.1) einen Wert gleich dem des Leistungsstroms (74.1) aufweist, sowie einen deaktivierten Zustand, wenn der Steuerstrom (74.2) einen Wert größer oder gleich dem Schwellenwert aufweist, in dem das Relais (74) den Leistungsstrom (74.1) sperrt, wobei der Speisestrom (60.1) einen Wert von null aufweist.

8. Antriebsanordnung nach einem der Ansprüche 6 bis 7, **dadurch gekennzeichnet, dass** die Belüftungsvorrichtung (52) mindestens einen Schalter aufweist, der zwischen einer Leistungsversorgung (76) und dem Relais (74) angeordnet ist und dazu ausgestaltet ist, einen Durchgangszustand einzunehmen, in dem der Schalter den Leistungsstrom (74.1) an das Relais (74) weiterleitet, und einen Sperrzustand, in dem der Schalter den Leistungsstrom (74.1) sperrt.

9. Antriebsanordnung nach einem der vorhergehenden Ansprüche, **dadurch gekennzeichnet, dass** der thermoelektrische Generator (64) stromab des Belüftungslochs (54) angeordnet ist, so dass ein durch das Belüftungsloch (54) durchgehender Luftstrom den thermoelektrischen Generator (64) beeinflusst.

10. Antriebsanordnung nach einem der vorhergehenden Ansprüche, **dadurch gekennzeichnet, dass** der thermoelektrische Generator (64) eine erste Seite (66.1) in Kontakt mit einer Kältequelle oder mit einer kalten Umgebung, die durch eine Kältequelle gekühlt wird, aufweist sowie eine zweite Seite (66.2) in Kontakt mit einer Wärmequelle oder einer warmen Umgebung, die durch eine Wärmequelle erwärmt wird, die einen Temperaturgradienten mit der Kältequelle oder der kalten Umgebung aufweist, und dass der thermoelektrische Generator (64) so angeordnet ist, dass seine zweite Seite (66.2) in Kontakt mit einer zu kühlenden Wärmequelle oder mit einer zu kühlenden warmen Umgebung ist.

11. Antriebsanordnung nach einem der vorhergehenden Ansprüche, **dadurch gekennzeichnet, dass** die Motorisierung (32) einen Triebwerkskern (38) aufweist, der durch ein Gehäuse (38.1) begrenzt wird, eine den Triebwerkskern (38) umgebende Außenwand (40), die von dem Gehäuse (38.1) beabstandet ist und den ringförmigen Kanal (36) begrenzt, sowie einen Zwischenbereich (44), der zwischen dem Gehäuse (38.1) des Triebwerkskerns (38) und der Außenwand (40) angeordnet ist, wobei die Außenwand (40) eine zu dem Triebwerkskern (38) gewandte Innenseite (Fint) und eine zu der Innenseite (Fint) entgegengesetzte Außenseite (Fext) aufweist, wobei der zu kühlende Bereich dem Zwischenbereich (44) entspricht und wobei das Belüftungsloch (54) die Außenwand (40) durchdringt.

12. Antriebsanordnung nach dem vorhergehenden Anspruch, **dadurch gekennzeichnet, dass** der thermoelektrische Generator (64) an der Außenwand (40) angeordnet ist und eine erste Seite (66.1) aufweist, die an der Außenseite (Fext) der Außenwand (40) gelegen und in Kontakt mit dem kalten Luftstrom ist, sowie eine zweite Seite (66.2) in Kontakt mit einer warmen Luft, die sich in dem Zwischenbereich (44) befindet.

13. Antriebsanordnung nach Anspruch 11, **dadurch gekennzeichnet, dass** der thermoelektrische Generator (64) an dem Gehäuse (38.1) des Triebwerkskerns (38) angeordnet ist und eine erste Seite (66.1) in Kontakt mit einer Luft, die sich in dem Zwischenbereich (44) befindet, sowie eine zweite Seite (66.2), die an das Gehäuse (38.1) angepresst ist, aufweist.

14. Flugzeug, das mindestens eine Antriebsanordnung nach einem der vorhergehenden Ansprüche aufweist.

## Claims

1. Aircraft propulsion assembly comprising an engine (32), a nacelle (34) positioned around the engine (32), an annular duct (36) positioned between the engine (32) and the nacelle (34) and configured to channel a cold air stream and at least one ventilation device (52) configured to cool at least one zone to be cooled of the propulsion assembly, the ventilation device comprising at least one ventilation hole (54) which emerges in the zone to be cooled, the ventilation device being regulated and comprising at least one valve (56) that is movable between a closed position in which the valve (56) shuts the ventilation hole (54) and an open position in which the valve (56) at least partially frees the ventilation hole (54), and at least one thermoelectric generator (64) configured to generate an electric current; **characterized in that** the ventilation device also comprises at least one servocontrol mechanism (78) configured to control the position of the valve (56) by using the electrical current generated by the thermoelectric generator (64).

2. Propulsion assembly according to the preceding claim, **characterized in that** the ventilation device (52) comprises at least one electric actuator (60) configured to displace the valve (56) in at least one first direction out of a direction going from the open position to the closed position and a direction going from the closed position to the open position.

3. Propulsion assembly according to the preceding claim, **characterized in that** the ventilation device (52) comprises at least one spring (62) configured to push and keep the valve (56) in the open position, the electric actuator (60) being configured to displace the valve (56) from the open position to the closed position against the efforts exerted by the spring (62).

4. Propulsion assembly according to one of Claims 2 and 3, **characterized in that** the ventilation device (52) comprises at least one electric cable (68) linking the thermoelectric generator (64) and the electric actuator (60) such that the electrical current generated by the thermoelectric generator (64) powers the electric actuator (60).

5. Propulsion assembly according to the preceding claim, **characterized in that** the ventilation device (52) comprises at least one converter (70) comprising a function configured to transform the electric current generated by the thermoelectric generator (64) into a power supply current (60.1) to power the electric actuator (60), a given value of the power supply current (60.1) being a function of a given value of the current generated by the thermoelectric generator (64) and corresponding to a given position of the valve (56).

6. Propulsion assembly according to one of Claims 2 and 3, **characterized in that** the ventilation device (52) comprises at least one relay (74) configured to receive a power current (74.1) and transmit it to the electric actuator (60) as power supply current (60.1) as a function of a control current (74.2) generated by the thermoelectric generator (64).

7. Propulsion assembly according to the preceding claim, **characterized in that** the relay (74) is configured to occupy an activated state, when the control current (74.2) has a value lower than a threshold value, in which the relay (74) allows the passage of the power current (74.1), the power supply current (60.1) having a value equal to that of the power current (74.1), and a deactivated state, when the control current (74.2) has a value greater than or equal to the threshold value, in which the relay (74) blocks the power current (74.1), the power supply current (60.1) having a zero value.

8. Propulsion assembly according to one of Claims 6 and 7, **characterized in that** the ventilation device (52) comprises at least one switch, positioned between a power supply (76) and the relay (74), configured to occupy an on state in which the switch transmits the power current (74.1) to the relay (74) and an off state in which the switch blocks the power current (74.1).

9. Propulsion assembly according to one of the preceding claims, **characterized in that** the thermoelectric generator (64) is positioned downstream of the ventilation hole (54) such that an air stream passing through the ventilation hole (54) impacts the thermoelectric generator (64).

10. Propulsion assembly according to one of the preceding claims, **characterized in that** the thermoelectric generator (64) comprises a first face (66.1) in contact with a cold source or with a cold ambience cooled by a cold source and a second face (66.2) in contact with a hot source or a hot ambience heated by a hot source which exhibits a temperature gradient with the cold source or the cold ambience and **in that** the thermoelectric generator (64) is positioned such that its second face (66.2) is in contact with a hot source to be cooled or with a hot ambience to be cooled.

11. Propulsion assembly according to one of the preceding claims, **characterized in that** the engine (32) comprises an engine core (38) delimited by a shroud (38.1), an outer wall (40) surrounding the engine core (38), away from the shroud (38.1) and delimiting the annular duct (36), and an intermediate zone (44) positioned between the shroud (38.1) of the engine core (38) and the outer wall (40), the outer wall (40) having an inner face (Fint) oriented towards the engine core (38) and an outer face (Fext) opposite the inner face (Fint), the zone to be cooled corresponding to the intermediate zone (44) and the ventilation hole (54) passing through the outer wall (40).

12. Propulsion assembly according to the preceding claim, **characterized in that** the thermoelectric generator (64) is positioned at the outer wall (40) and has a first face (66.1) situated at the outer face (Fext) of the outer wall (40) and in contact with the cold air stream and a second face (66.2) in contact with a hot air present in the intermediate zone (44).

13. Propulsion assembly according to Claim 11, **characterized in that** the thermoelectric generator (64) is positioned at the shroud **(38.1)** of the engine core (38) and has a first face (66.1) in contact with air present in the intermediate zone (44) and a second face (66.2) pressed against the shroud (38.1).

14. Aircraft comprising at least one propulsion assembly according to one of the preceding claims.
